# EUROPEAN PATENT APPLICATION

(11) **EP 3 270 095 A1**
(43) Date of publication of application: **17.01.2018**
(21) Application number: 17181130.0
(22) Date of filing: 13.07.2017
(51) Int. Cl.: G01B 9/02, G01N 21/88

(54) **SYSTEM AND METHOD FOR SURFACE INSPECTION**

(30) Priority: 13.07.2016 US 201662361563 P; 15.08.2016 US 201662375150 P; 06.06.2017 US 201762515652 P; 06.06.2017 US 201762515657 P; 12.06.2017 US 201762518186 P; 12.06.2017 US 201762518206 P; 12.06.2017 US 201762518227 P; 12.06.2017 US 201762518249 P; 12.06.2017 US 201762518256 P; 12.06.2017 US 201762518059 P
(71) Applicant: Sightline Innovation Inc., Toronto, Ontario M6H3A7 (CA)
(72) Inventor: TRENHOLM, Wallace, Toronto, Ontario M5C1S3 (CA); MAVINKURVE, Maithili, Markham, Ontario L3P7R9 (CA); CASSIDY, Jason, Winnipeg, Manitoba R3C1J8 (CA)
(74) Representative: TBK

(57) **Abstract**

Systems and methods for surface inspection for imaging an object via an optical coherence tomography (OCT) imaging modality are provided. The system includes an OCT imaging module for generating imaging data from a surface under inspection, including: an electromagnetic radiation source for interrogating the object with light; an optical system having an interferometer for generating an interference pattern corresponding to the light backscattered from the object; and a detector for detecting the interference pattern and generating imaging data therefrom; a motion controller device for moving at least one component of the OCT imaging module relative to the object, the motion controller device moving the OCT imaging module such that a surface of the object is within a depth of field of the OCT imaging module; and a computational module for: aggregating the imaging data; and determining the presence or absence of surface defects in the imaging data.

## Description

### TECHNICAL FIELD

The present disclosure relates generally to imaging. More particularly, the present disclosure relates to a surface inspection system and method for optical coherence tomography.

### BACKGROUND

Surface inspection is important in a broad range of fields, including industrial applications such as manufacturing and construction. Surface inspection techniques are often used to detect defects or irregularities in an object or material under inspection. Processes for surface inspection may be manual, automatic, or a combination of both.

In manufacturing, construction, and other production environments, inaccurate inspection can lead to wasted product or materials, loss of time, and can contribute to process inefficiencies. Manufacturing processes can be prone to the development of defects in the surfaces of products. For example, in automotive manufacturing settings, numerous paint and other defects are encountered such as paint sags, dirt, splits, and "orange peeling", scratches, dents and the presence of foreign materials such as metal shavings. Defects on the painted surface of a vehicle are not acceptable to consumers. Paint inspection of a full vehicle requires extensive human inspection which may be prone to human error. Automated methods of surface inspection may be used, but can require the vehicle to be stationary for a period of time. This can be disruptive to the manufacturing process, affect production output and demand particular staffing and maintenance requirements.

Surfaces in industrial settings such as manufacturing and construction tend to be large and, accordingly, traditional surface inspection and imaging processes and techniques can be challenging to implement and may be inefficient. Advanced surface imaging and inspection technologies providing improved accuracy and resolution, such as optical coherence tomography ("OCT") and hyperspectral imaging, are typically limited to scanning smaller objects (e.g. the human eye). This is in part because going beyond a small field of view can drastically increase the amount of imaging data that requires processing. Manufacturing and other industrial applications also demand the automated processes and cannot rely on human evaluation of the data, unlike applications such as medicine. As a result, advanced imaging techniques such as OCT and hyperspectral imaging have not been adopted for industrial inspection applications such as manufacturing and construction, where speed and scalability are important considerations.

### SUMMARY

In an aspect, there is provided a surface inspection system for imaging an object via an optical coherence tomography (OCT) imaging modality, the system comprising: an OCT imaging module for generating imaging data from a surface of the object, comprising: an electromagnetic radiation source for interrogating the object with light; an optical system having an interferometer for generating an interference pattern corresponding to the light backscattered from the object; and a detector for detecting the interference pattern and generating imaging data therefrom; a motion controller device for moving at least one component of the OCT imaging module relative to the object, the motion controller device moving the at least one component of the OCT imaging module such that the surface of the object is within a depth of field of the OCT imaging module; and a computational module for: aggregating the imaging data; and determining the presence or absence of surface defects in the imaging data.

In a particular case, moving the at least one component of the OCT imaging module comprises translating or rotating of the at least one component of the OCT imaging module relative to the object.

In another case, moving the at least one component of the OCT imaging module comprises radial actuation of the at least one component of the OCT imaging module to maintain a predetermined angle of incidence between the OCT imaging module and the surface of the object.

In yet another case, moving the at least one component of the OCT imaging module comprises linear actuation of the at least one component of the OCT imaging module to maintain a predetermined distance between the OCT imaging module and object, the predetermined distance enabling the surface of the object to be in focus of the OCT imaging module.

In yet another case, the motion controller device for moves the at least one component of the OCT imaging module based on a motion control model, the motion control model using geometries of the surface of the object such that the surface of the object is within a depth of field of the OCT imaging module.

In yet another case, the geometries of the surface of the object are pre-existing geometries received by the motion controller device.

In yet another case, the geometries of the surface of the object are measured using a positional sensor directed at the object.

In yet another case, the computational module comprises a neural network for receiving the imaging data at an input layer and generating the determination at an output layer based on a trained classification model.

In yet another case, the imaging data comprises interferometric data generated by the optical system of the OCT imaging module.

In yet another case, the classification model can be based on supervised learning, unsupervised learning, semi-supervised learning, groundtruther learning, or reinforcement learning.

In another aspect, there is provided a method for surface inspection for imaging an object via an optical coherence tomography (OCT) imaging modality using an OCT imaging module, the method comprising: moving the at least one component of the OCT imaging module relative to the object such that a surface of the object is within a depth of field of the OCT imaging module; performing, with the OCT imaging module: interrogating the object with light from a light source; detecting light backscattered from the object to detect an interference pattern; and generating imaging data from the interference pattern; aggregating the imaging data; and determining the presence or absence of surface defects in the imaging data.

In a particular case, moving the at least one component of the OCT imaging module comprises translating or rotating of the at least one component of the OCT imaging module relative to the object.

In another case, moving the at least one component of the OCT imaging module comprises radial actuation of the at least one component of the OCT imaging module to maintain a predetermined angle of incidence between the OCT imaging module and the surface of the object.

In yet another case, moving the at least one component of the OCT imaging module comprises linear actuation of the at least one component of the OCT imaging module to maintain a predetermined distance between the OCT imaging module and object, the predetermined distance enabling the surface of the object to be in focus of the OCT imaging module.

In yet another case, the at least one component of the OCT imaging module is moved based on a motion control model, the motion control model using geometries of the surface of the object such that the surface of the object is within a depth of field of the OCT imaging module.

In yet another case, the geometries of the surface of the object are pre-existing geometries.

In yet another case, the geometries of the surface of the object are measured.

In yet another case, determining the presence or absence of surface defects comprises using a neural network for receiving the imaging data at an input layer and generating the determination at an output layer based on a trained classification model.

In yet another case, the imaging data comprises interferometric data generated by the OCT imaging module.

In yet another case, the method further comprises denoising the imaging data using a neural network.

These and other aspects are contemplated and described herein. It will be appreciated that the foregoing summary sets out representative aspects of systems and methods to assist skilled readers in understanding the following detailed description.

### BRIEF DESCRIPTION OF THE DRAWINGS

Preferred embodiments of the present disclosure will now be described, by way of example only, with reference to the attached Figures, wherein:
FIG. 1 shows a system for surface inspection comprising an OCT imaging module for a vehicle in motion along an automobile manufacturing paint line, in accordance with an embodiment;
FIG. 2 shows a method for surface inspection for the system of FIG. 1, in accordance with an embodiment;
FIG. 3 shows an optical system having a Michelson-type interferometer setup for use in an OCT imaging module of a surface inspection system, in accordance with an embodiment;
FIG. 4 shows a distributed surface inspection system having a plurality of OCT imaging modules with motion control, in accordance with an embodiment;
FIG. 5 shows a block diagram of a surface inspection system having an integrated control system for automating and optimizing the surface inspection operation, in accordance with an embodiment;
FIG. 6A shows a representation of motion control inputs for a motion control system to be used with a surface inspection system;
FIG. 6B shows a diagram of motion coordinate systems for use with a motion control system as part of a surface inspection operation;
FIG. 6C shows of a motion control system using focal plane management techniques for curved surfaces in a surface inspection operation;
FIG. 7 shows a method of inspecting a surface using a neural network, for use at an OCT imaging module of a distributed surface inspection system, in accordance with an embodiment;
FIG. 8 shows a block diagram of a surface inspection system, operating in training and normal modes, in accordance with an embodiment.

### DETAILED DESCRIPTION

Before the subject matter of the present disclosure is described in further detail, it is to be understood that the invention is not limited to the particular embodiments described, as such may, of course, vary. It is also to be understood that the terminology used herein is for the purpose of describing particular embodiments only, and is not intended to be limiting, since the scope of the present disclosure will be limited only by the appended claims.

For simplicity and clarity of illustration, where considered appropriate, reference numerals may be repeated among the Figures to indicate corresponding or analogous elements. In addition, numerous specific details are set forth in order to provide a thorough understanding of the embodiments described herein. However, it will be understood by those of ordinary skill in the art that the embodiments described herein may be practiced without these specific details. In other instances, well-known methods, procedures and components have not been described in detail so as not to obscure the embodiments herein. Also, the description is not to be considered as limiting the scope of the embodiments described herein.

Various terms used throughout the present disclosure may be read and understood as follows, unless the context indicates otherwise: "or" as used throughout is inclusive, as though written and/or; singular articles and pronouns as used throughout include their plural forms, and vice versa; similarly, gendered pronouns include their counterpart pronouns so that pronouns should not be understood as limiting anything described herein to use, implementation, performance, etc. by a single gender; "exemplary" should be understood as "illustrative" and "exemplifying" and not necessarily as "preferred" over other embodiments. Further definitions for terms may be set out herein; these may apply to prior and subsequent instances of those terms, as will be understood from a reading of the present disclosure/description.

Unless defined otherwise, all technical and scientific terms used herein have the same meaning as commonly understood by one of ordinary skill in the art to which this invention belongs. Although any methods and materials similar or equivalent to those described herein can also be used in the practice or testing of the present invention, a limited number of the exemplary methods and materials are described herein.

It must be noted that as used herein and in the appended claims, the singular forms "a", "an", and "the" include plural referents unless the context clearly dictates otherwise.

Any module, unit, component, server, computer, terminal, engine, or device exemplified herein that executes instructions may include or otherwise have access to computer readable media such as storage media, computer storage media, or data storage devices (removable and non-removable) such as, for example, magnetic discs, optical disks, or tape. Computer storage media may include volatile and non-volatile, removable and non-removable media implemented in any method or technology for storage of information, such as computer readable instructions, data structures, program modules, or other data. Examples of computer storage media include RAM, ROM, EEPROM, flash memory or other memory technology, CD-ROM, digital versatile discs (DVD) or other optical storage, magnetic cassettes, magnetic tape, magnetic disk storage or other magnetic storage devices, or any other medium which can be used to store the information and which can be accessed by an application, module, or both. Any such computer storage media may be part of the device or accessible or connectable thereto. Further, unless the context clearly indicates otherwise, any processor or controller set out herein may be implemented as a singular processor or as a plurality of processors. The plurality of processors may be arrayed or distributed, and any processing function referred to herein may be carried out by one or by a plurality of processors, even though a single processor may be exemplified. Any method, application or module herein described may be implemented using computer readable/executable instructions that may be stored or otherwise held by such computer readable media and executed by the one or more processors.

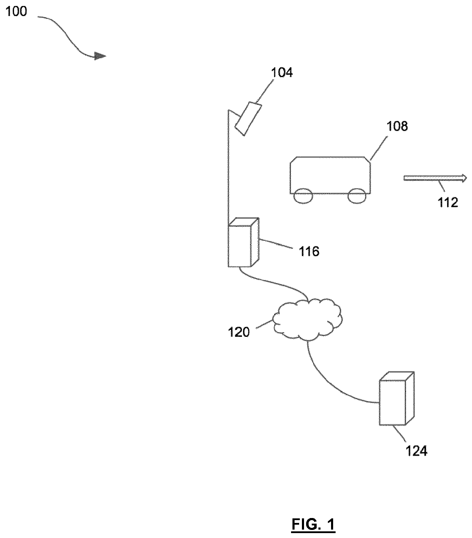

Referring now to FIG. 1, shown therein is a surface inspection system 100 using an OCT imaging modality, in accordance with an embodiment. The system 100 comprises an OCT imaging module 104, a computing module, and an object under inspection 108 (such as a vehicle) moving along a direction of motion 112. Generally, the OCT imaging module 104 operates to scan the object 108 in order to generate imaging data. In some cases, the system 100 also acquires hyperspectral imaging data. Any reference herein to "imaging data" should be taken to include hyperspectral imaging data in addition to OCT imaging data, where appropriate.

The OCT imaging module 104 comprises an optical system, an optical source, and a detector. The computing module comprises a local computing module 116, which may be communicatively linked, for example via a network 120, to a remote computing module 124. The computing module may be used for processing and analysis of imaging data received from the OCT imaging module 104. Further, the remote computing module 124 may host a user-accessible platform for invoking services, such as reporting and analysis services, and for providing computational resources to effect machine learning techniques.

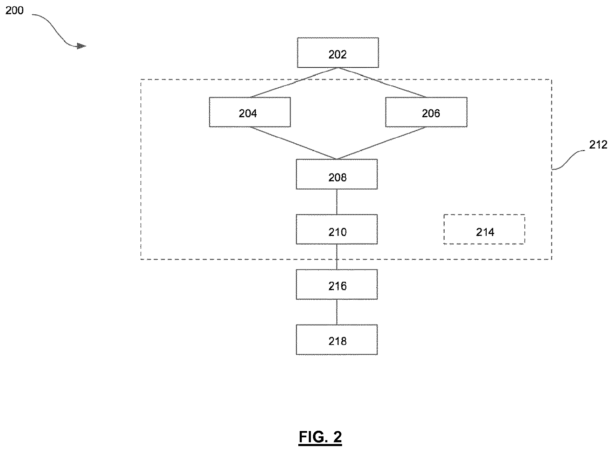

Referring now to FIG. 2, shown therein is a method 200 of surface inspection using an OCT imaging modality, for example using system 100, in accordance with an embodiment. The method 200 may be used for inspecting the surface of an object when in motion, relative to the OCT module 104, in particular for the purposes of detecting surface defects or irregularities. The method 200 may further determine the relative location of such defects. The method 200 aggregates imaging data generated by the OCT imaging module 104, and may include the application of object motion compensation techniques.

At block 202, the OCT imaging module scans the object 108, which may be in motion. In some cases, the object 108 can be stationary and the OCT imaging module 104 is moved as required to scan the surface of the object. The OCT imaging module scans the object via an OCT imaging modality, such as interferometry. In doing so, light backscattered from the surface of the object 108 is detected by a detector of the OCT imaging module 104. An interference pattern corresponding to the backscattered light received by the detector can be converted into a signal via a data acquisition device, such as a high-speed digitizer.

At block 204, the computing module, for example local computing module 116, receives imaging data from the detector of OCT imaging module 104, the imaging data comprising an A-scan.

Optionally, at block 206, the computing module receives hyperspectral imaging data from the OCT imaging module 104. At blocks 204 and 206, the imaging data may be processed in order to produce a two-dimensional or three-dimensional representation of the surface of object 108. Particularly, mathematical calculations (e.g. Fourier transform) may be carried out on the imaging data, for example to simplify data manipulation and analysis by the computing module.

At block 208, the computing module aggregates the imaging data from the OCT imaging module collected at blocks 204 and 206. The aggregation technique may involve stacking images/scans comprising the imaging data according to image processing techniques. In an embodiment, aggregation of imaging data may include the formation of a B-scan from a plurality of A-scans.

As illustrated by block 212, denoising and other image processing techniques may be carried out at various blocks of method 200. Image processing techniques include applying Fourier transforms, wavelet transforms, applying filters, thresholding and edge detection techniques to imaging data. Other image processing techniques would apply to those of skill in the art. Denoising may include applying motion compensation to the imaging data. Motion compensation may comprise the determination of a motion vector relating to motion of the object during imaging, and compensation for any distortion or defects computed to be introduced by the determined motion of the object as indicated as indicated by the motion vector. The motion vector may be determined using sensor readings from an accelerometer coupled to the object, or other suitable techniques. Denoising may also include the application of other image stacking mechanisms and techniques.

At block 214, optionally, imaging data may be received from multiple stages of a multistage surface inspection. For example, in the manufacturing context, imaging data may be received from different stages of a painting process. The imaging data from multiple stages may be cross-correlated in order to more accurately determine the presence of surface defects. For example, the presence or absence of a surface defect at one stage of inspection for a particular area of an object, may be cross-correlated to measurements of the same area of the object at a different stage in order to generate a global value indicating the likelihood of the presence of a surface defect at the imaged area.

At block 216, once the imaging data is aggregated, it may be analyzed in order to determine the presence of any surface defects. In addition, the determined motion vector may be used for the determination of the relative position of any determined surface defects on the surface of the object. The relative position of a surface defect may be used for remediation efforts.

At block 218, an output may be generated in response to the determination of surface defects indicating the presence or absence of surface defects, as well as optionally the location of such defects on the object. The output may effect a state change in a workflow operating using operational states, in a manner similar to a finite state machine. For example, an output indicating the absence of surface defects during a paint or other inspection workflow state may be processed by the computing module and may cause a change of operational states, which may result in the vehicle under inspection entering a different stage of a manufacturing process, for example on an assembly line.

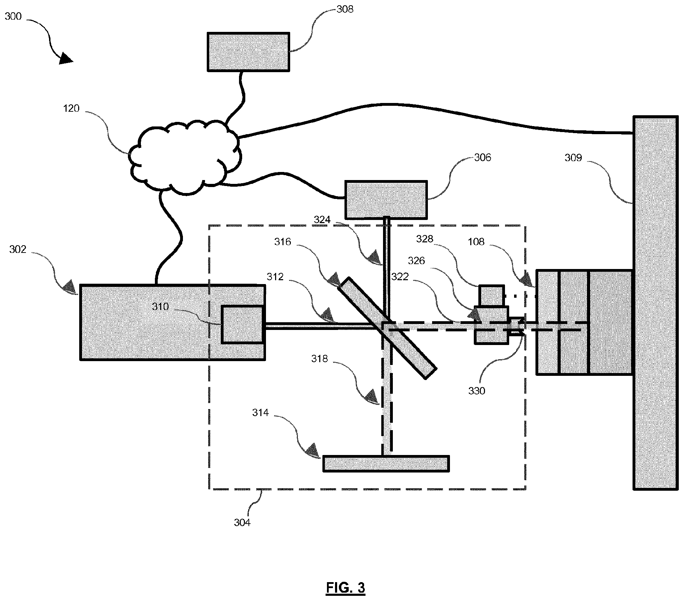

Referring now to FIG. 3, shown therein is a surface inspection system 300 using an OCT imaging modality, in accordance with an embodiment. System 300 comprises an OCT imaging module and a computing module. The OCT imaging module comprises an optical system 304 having an interferometer-type setup, a optical source 302, and a detector 306. The optical system 304 further comprises an input arm 312, beam splitter 316, reference arm 318, sample arm 322, and output arm 324. Light from the optical source 302 is transmitted to the optical system 304, and optical system 304 carries out a detection operation in accordance with an interferometric detection modality. The detector 306 may generate imaging data corresponding to an interference pattern based on backscattered light from the surface of the object 108. In some cases, the system 300 can include an object translator 309 to move the object 108 relative to the optical beam and/or the OCT module. The object translator 309 can be, for example, a conveyor, a robotic system, or the like.

The optical source 302 can be any light source suitable for use with an interferometric imaging modality, such as a laser or light emitting diode (LED). Particularly, in some implementations, the optical source 302 is a tunable laser the wavelength of which can be altered (i.e. swept) in a controlled manner, for example to sweep a wide wavelength range (e.g. 110nm) at high speed (e.g. 20KHz). In an embodiment, a tunable laser is used and spectral components of backscattered light are encoded in time. A spectrum (e.g. hyperspectral information) can be acquired from single successive frequency steps or sweeps of the tunable laser and can be reconstructed by the computing module 308 via mathematical calculation such as Fourier transform. The computing module 308 may be a local computing module or remote computing module, and may be communicatively linked to various components of the system 300, such as via network 120. Using a tunable laser may allow simplification of the optical system setup of the OCT imaging module. For example, using a tunable laser can negate the requirement for a high performance spectrometer and charge coupled device ("CCD") camera or similar detector array. An interferometric signal can be collected from the light backscattered from the object 108, and may be collected at the photodetector surface/strike the photodetector surface] registered on the photodetector surface present on the detector 306. In an embodiment, optical source 302 comprises a tunable laser with a centre wavelength of 1310nm, wherein the wavelength of the emitted light is continuously scanned over a 110nm range, with a scan rate of 20kHz and a coherence length of over 10mm. Having such a setup may allow detailed imaging over an extended depth as well as real-time monitoring and analysis.

In a further embodiment, the optical source 302 may be a low coherence light source such as white light or an LED. Using a low coherence light source can facilitate extraction of spectral information from the imaging data by distributing different optical frequencies onto a detector array (e.g. line array CCD) via a dispersive element, such as a prism, grating, or other suitable device. This can occur in a single exposure as information of the full depth scan can be acquired. In such an embodiment, hyperspectral information is acquired in the frequency domain when the recombined beam is split into its spectral components via the dispersive element and registered on a linear detector array present on the detector 306. Interferometric signals can be obtained from the spectra by splitting the recombined beam via mathematical calculation, such as inverse Fourier transform. These interferometric signals can then be combined to form a 2D image ("B-scan"), which can then optionally be combined to form a 3D image ("C-scan") of a surface. The OCT imaging module may scan the target object in two lateral dimensions, such as in raster scanning, in a single point scanning setup in order to create a plurality of two dimensional images that can optionally be combined to construct a three dimensional image.

FIG. 3 shows further exemplary aspects of the optical system 304. The optical system 304 comprises an interferometer having input arm 312, a collimator 310, beamsplitter 316, reference arm 318, a reflective element 314, sample arm 322 and output arm 324. Light from the optical source 302 is directed to the optical system 304 and guided by the collimator 310, which can guide the light via collimation. The resultant incident beam travels through the input arm 312 and is directed to beam splitter 316. The beam splitter 316 splits the incident beam into a reference beam and sample beam. In an embodiment, the sample arm 322 includes a second optic for focusing the sample beam on the object 108. The reference beam travels along the reference arm 318 to reflective element 314, while the sample beam travels along the sample arm 322 towards the surface of the object 108. The reference beam and sample beam are each reflected back towards the beamsplitter 316, at which point the reference beam and sample beam are recombined into a recombined beam and directed along the output arm 324 to the detector 306. In an embodiment, further optics can be present along the output arm for focusing the recombined beam on the detector 306. The resulting phase difference between the reference beam and sample beam is detected by the detector 306 as a change in intensity of the recombined beam reaching the detector 306.

Optics included in optical system 304 may be dimensioned to focus at a certain distance from the object 108. Optics may include lenses or other optical apparatus or device suitable to control, guide, navigate, position etc. the light beam in a desired manner. In some cases, the inclusion of a lens in the optical system 304 may result in unwanted lens error affecting the resulting image. Distortion is one such lens error. A distortion is an optical aberration that misplaces imaging information geometrically, for example by deforming and bending physically straight lines and making them appear curved in an image. Aberrations of this sort can cause the actual position of an object or element in the image to appear as though it is in a different location than it actually is, which may decrease measurement accuracy. Fortunately, such lens errors can be remediated by calibrating, calculating or mapping the distortion out of the image to partially improve the accuracy. Accordingly, systems and methods of the present disclosure contemplate computing module 308 implementing one or more computer programs for correcting the effects of lens and/or other optical errors, such as distortion. Examples of software used for such corrective purposes include Adobe Camera RAW, Lightroom, Aperture, DxO Optics, PTLens, etc. Corrective software may run on a local or remote computing module. In some cases, system 300 may include a telecentric lens, the properties and function of which may reduce the need for corrective software. Unlike certain applications of OCT technology in the medical field, which may require the inclusion of often expensive optics such as a telecentric lens in order to limit curvature of the image to obtain necessary precision and accuracy for accurate identification of components of the image (e.g. in diagnosing), surface inspection applications such as those described herein can more readily incorporate the use of post-processing techniques such as software correction.

In an embodiment, the optical system 304 can include fiber optic components. For example, the optical system 304 may comprise a fiber optic interferometer (e.g. input, object, reference, and output arms) having a fiber optic coupler. The fiber optic coupler may allow a single fiber input to be split into multiple outputs, or vice versa.

In some cases, there may be a scanner head 326 to direct the sample beam onto the object 108. In some cases, the system 300 can include a distance measurement module 328 for determining the distance between the scanner head 326 and the object 108. The distance measurement module 328 may be associated with, or separate from, the scanner head 326. In some embodiments, the optical system 304 (for example, the scanner head 326) can include a beam steering device 330 to direct light from the optical source 302 to a particular location on the surface of the object 108. By continually directing the light via beam steering device 330 in such a manner, the optical system 304 can scan object 108; for example, employing line scanning and/or raster scanning techniques. The beam steering device may comprise a mirror galvanometer (e.g. one- or two-dimensional), a single axis scanner, microelectromechanical system (MEMs)-based scanning mechanism, rotating scanner, or other suitable mechanism for beam steering. The beam steering device may be controlled electromechanically, by programmable software, the computing module 308 or other suitable means.

In some implementations, the system 300 may include an amplification mechanism; for example, a doped fiber amplifier, a semiconductor amplifier, a Raman amplifier, a parametric amplifier, or the like. The amplification mechanism can be used to amplify the signal of the optical source 302 and/or to increase quantity of photons backscattered off the surface under inspection and collected on the detector 306. By using the amplification mechanism, sensitivity of the system may be increased.

The detector 306 of system 300 can be any suitable photodetector. In a particular case, the detector 306 can be a balanced photodetector, which can have an increased signal to noise ratio. In further cases, the detector 306 may comprise a photoelectric-type photodetector, such as a charge-coupled device (CCD) or complementary metal-oxide semiconductor (CMOS). The detector 306 may operate by photoemission, photovoltaic, thermal, photochemical, or polarization mechanism, or other mechanism through which electromagnetic energy can be converted into an electrical signal.

Upon receiving the recombined beam, the detector 306 can convert the radiance/intensity of the recombined beam into an electrical signal. In some cases, the electrical signal may then be converted to a digital signal, and modified by signal conditioning techniques such as filtering and amplification. In some cases, the interference pattern corresponding to the backscattered light can be converted into a signal by the detector 306, via for example a high-speed digitizer. Signal conditioning and conversion may be carried by a data acquisition device communicatively connected to the detector 306 of the OCT imaging module 104 and to computing module 308. The digital signal can then be sent to a processor such as the computing module 308 for further manipulation. The computing module 308 may include programmable software, such as application software that may be developed through a general purpose programming language, such as LabVIEW, C#, or other suitable language.

In an embodiment, the detector 306 is configured to acquire hyperspectral information. For example, the detector 306 can collect hyperspectral information as a set of images. Each image represents a narrow wavelength range of the electromagnetic spectrum or spectral band. The images can be combined by computing module 308 to form a three-dimensional hyperspectral data cube with two spatial dimensions and one spectral dimension for processing and analysis, where the x and y dimensions represent two spatial dimensions (x,y) and A represents a spectral domain. In an embodiment of the present disclosure, each two-dimensional output represents a full slit spectrum (with x and λ dimensions). A slit spectra is obtained by projecting a strip of the object under inspection onto a slit and dispersing the slit image via a dispersion element such as a prism or grating. The object under inspection may then be analyzed by line, for example by push-broom scanning technique, where the spatial dimension is acquired through movement of the object under inspection (e.g. conveyor belt) or by scanning of the OCT imaging module 104 itself. In another embodiment, point scanning may be used where a point-like aperture is used instead of a slit, and the detector 306 is one-dimensional instead of two. In an embodiment employing pushbroom scanning, one narrow spatial line is imaged at a time, with this narrow spatial line split into its spectral components before reaching a sensor array of detector 306.

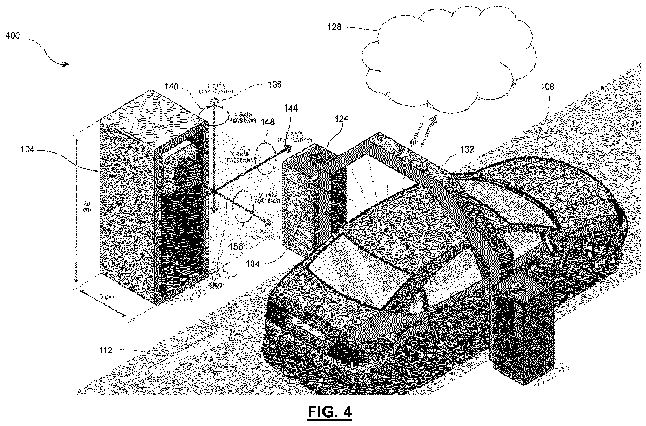

Referring now to FIG. 4, shown therein is a system 400 for surface inspection using an OCT imaging modality, in accordance with an embodiment. The system 400 comprises a distributed imaging system having a plurality of OCT imaging modules 104 arranged in a configuration for simultaneously collecting imaging data from different segments of the object 108. In some cases, the object 108 may be moved in a direction of motion 112 to facilitate scanning of the surface of object 108. While the configuration shown in FIG. 4 is an arch 132, the configuration may be take any form wherein multiple OCT imaging modules 104 scan segments of the object 108 under inspection. The system 400 may include a plurality of local computing modules, with each local computing module communicatively linked to a particular OCT imaging module 104. In some cases, the local computing module can be embedded within the OCT imaging module 104. In a particular case, the local computing module is a Nvidia TK1. The local computing modules of system 400 can be communicatively linked, for example via a network, to a remote computing module. The remote computing module and local computing modules of system 400 may operate according to a master-slave architecture. In a present embodiment, the remote computing module is a Nvidia TK1. The remote computing module of system 400 may be located on the inspection site. In some variations, the remote computing module may be communicatively linked to a cloud-based system 128.

Individual OCT imaging modules 104 of system 400 may include a motion control mechanism and/or motion sensor, which may form part of a control system loop such as those described in the present disclosure. In some implementations, the system 400 includes a motion control model and actuation mechanism responsible for moving the OCT imaging module 104 during a surface inspection operation. Particularly, the motion control model and actuation mechanism may facilitate movement of the OCT imaging module 104 along one or more axes of translation and/or rotation, such as x-axis translation 144 and rotation 148, y-axis translation 152 and rotation 156, and z-axis translation 136 and rotation 140.

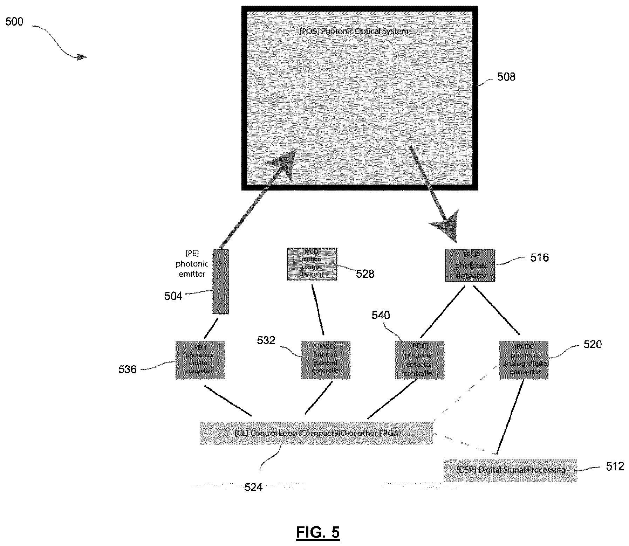

Referring now to FIG. 5, a system 500 for surface inspection having a motion control system comprising a motion control model and actuation is shown, in accordance with an embodiment. The system 500 includes a optical source 504, optical system 508, and digital signal processing unit 512. The optical source 504, optical system 508, and a detector 516 may together compose an OCT imaging module, such as OCT imaging module 104. The optical source 504 may be a laser or other appropriate light source for interrogating a target surface according to a given OCT imaging modality. The optical source 504 emits a beam that is directed to the target surface through the optical system 508. The optical system 508 carries out a detection operation on the sample, in accordance with an interferometry-based detection modality, generating a signal. The signal received by the detector 516 is converted to a digital signal by a photonic analog-digital converter 520. The digital signal processing unit 512 applies signal processing functions and techniques to the digital signal.

Aspects and processes of system 500 may be controlled by a control loop 524. The control loop 524 can be used to increase automation and optimization of detection operations and parameters and to reduce human intervention requirements. Motion of the OCT imaging module 104 can be controlled by a motion controller device 528. The motion controller device 528 can actuate aspects of OCT imaging module 104, carrying out desired movements such as moving the OCT imaging module 104 in one or more directions relative to the object 108. Such movements may include translation and/or rotation. For example, in an embodiment, the motion controller 528 device facilitates radial and/or linear movement of the OCT imaging module 104. Radial actuation may be used to maintain a desired angle of incidence, such as 90 degrees, between the OCT imaging module 104 and the target surface so the light from the optical source 504 strikes the target surface at an optimal angle (perpendicular) to produce a desired effect (e.g. maximizing the light energy backscattered from the target surface). Linear actuation can be used to maintain or assume a desired "stand-off distance" or "working distance" between the OCT imaging module 104 and the object surface, enabling the object surface to stay in focus. The motion controller device 528 may be controlled by a motion control controller 532, such as a microcontroller, which may be implemented as part of the computing module.

In some cases, system 500 may include a high frequency actuation mechanism, such as voice coil motor actuation, for assisting real-time depth of field compensation to correct for distortion caused by movement of the object relative to the OCT imaging module 104. The high frequency actuation mechanism can move the OCT imaging module 104 and/or one or more components of the optical system 504 (e.g. lens). In a particular embodiment, the high frequency actuation mechanism moves the OCT imaging module 104 where the working distance is greater than the distance the focal plane can actuate.

The optical source 504 of system 500 is controlled by an optical source controller 536, with the optical source 504 configured to emit light according to the interferometric detection modality employed. The photonic detector 516 may be controlled by a photonic detector controller 540. The motion control controller 532, photonics emitter controller 536, and photonic detector controller 540 may all be communicatively linked in control loop 524, which may comprise an FPGA or other device suitable for carrying out the desired tasks. The control loop 524 may be communicatively linked to the digital signal processing unit 512.

Motion control and actuation of the OCT module 104 may be based on and driven by a motion control model. In some cases, the motion control model can be configured to assist in real-time system configuration changes such as depth of field compensation in response to distortion caused by the movement of the object. The motion control model may utilize as an input pre-existing knowledge of object geometries in order to drive actuation. Alternatively, the model may rely on real-time determination of object geometries, such as through the use of a positional sensor, which may, in some cases, be located on the OCT imaging module 104. The motion control model may leverage digital signal processing techniques in executing motion control of the OCT imaging module 104.

In an embodiment, the system 500 may have implementation of the motion control model wherein a motion control action is first completed on the imaging module 104. Next, a photonic emission takes place. Next, a second motion control action is completed. Next, a photonic detection operation is carried out. Next, a third motion control action is completed.

In some cases, the motion control model can be scaled down to an individual OCT imaging module 104 in a distributed system. For example, the motion control model can be distributed to the local computing module of an individual OCT imaging module 104 and to remote computing module 124. In such variations, the remote computing module 124 may perform orchestration operations. The local computing module and remote computing module 124 may comprise master-slave architecture with a distributed motion control methodology.

Motion control of system 500 or other systems and methods described herein may include focal plane management techniques for scanning of objects having complex geometries by the OCT module and other purposes. In an embodiment, the system 500 may develop and/or employ focal plane management techniques based on a geometric model of the object 108. In some cases, the geometric model of the object may be pre-existing and known, such as with a CAD model of the object, or may be generated in real-time during a scan by the OCT module 104. The present disclosure contemplates at least four different motion control techniques that may be used individually or in some combination of two or more. Geo-positioning comprises motion control effecting movement and positioning of the OCT imaging module 104. In some instances, the OCT module 104 can include a mounting device. For example, in some variations geo-positioning motion control influences where the OCT imaging module is positioned relative to the object. Pointer-positioning comprises a motion control model and actuation influencing where the OCT imaging module is pointing. In other words, pointer-positioning may control a robot arm or the positioning and/or movement of the OCT imaging module relative to the mounting device. Beam positioning comprises a motion control system influencing the positioning of the laser beam emitted from the light source of the OCT imaging module relative to the target. Beam positioning may be effected by a beam steering device, such as beam steering device of OCT imaging module, controlled by motion control system. Optical positioning may include controlling the positioning of the focal plane of the optical system within the OCT imaging module via a motion control system. This may include moving a lens or other component of the optical system in order to manage the focal plane length. In some cases, actuation for these motion control techniques may be achieved, for example, through the use of voice coil actuation or other high speed focal plane management technique, where appropriate.

Some variations of the systems and methods of the present disclosure may include or utilize a distance measurement module, such as a laser scanning device, communicatively linked to the surface inspection system. The distance measurement module can be used for scanning and determining the geometry surface profile of the object; in an embodiment, this is done according to a laser scanning modality (e.g. phase shift measurement; time of flight measurement). Generally, the distance measurement module operates in a manner as is known in the art to carry out one of the aforementioned scanning modalities. The distance measurement module may include a laser, a beam steering device, a detector, and a controller. An optical beam is directed to the object via the beam steering device, the beam is reflected off the target object and received at the detector, and the controller calculates a distance travelled by the beam which, when a series of measurements are taken, can facilitate generation of a three dimensional model of the object. Scan data from the distance measurement module representing the geometry of the object can be sent to the motion control system of the OCT system. Scan data may comprise a three dimensional point cloud for generating a 3D model of the object. Use of the distance measurement module to obtain geometric data/surface profile of the object may in some cases be used instead of or in addition to a CAD model and proximity sensor(s).

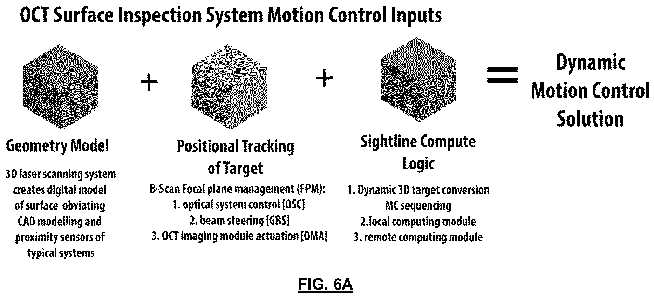

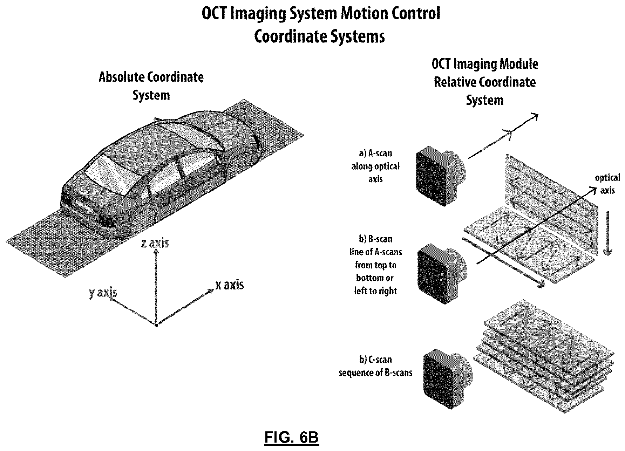

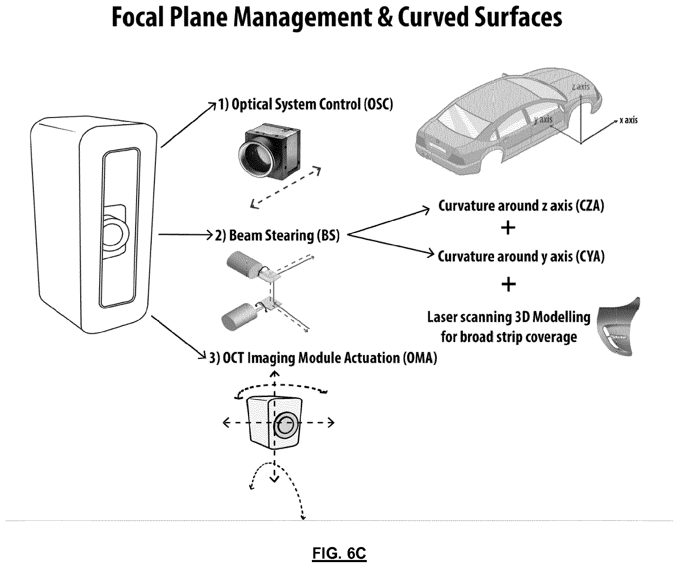

In an embodiment, the motion control system may receive as inputs a geometry model of the object and position tracking information/data of the object. The position tracking information may be with respect to a conveyor (FIG. 6A). Further, the motion control system may include an absolute coordinate system and a relative coordinate system as depicted in FIG. 6B. The absolute coordinate system may comprise an x-axis, a y-axis, and a z-axis, wherein the x-axis is defined by the object's motion down the conveyor; the y-axis is defined where positive is to the left of the object relative to the direction of motion of the target object down the conveyor; and the z-axis is defined in the vertical direction (e.g. from the ground upwards through the target object). The OCT imaging module may include a relative coordinate system wherein an A-scan comprises an axial pixel penetrating into the surface of the target object; a B-scan comprises a line scan of A-scans from an inline scan (i.e. along optical axis), for example from top to bottom (line traverses vertically on surface) or from left to right (line traverses horizontally on surface); and a C-scan comprises a sequence of B-scans. Focal plane management in the B-scan may include optical controls (e.g. optical positioning) such as by lens focus, beam steering (e.g. galvo), and/or actuation of the OCT imaging module (FIG. 6C).

Curvature around the z-axis (CZA) may be managed by using beam steering to offset the angle of incidence of the light beam on the surface of the target object. This may include looking upstream of the conveyor movement for a curve that faces a first end of the target object (e.g. front), and looking downstream for curvature that faces a second end of the target object (e.g. rear). Curvature around the Y-axis (CYA) may be managed in a manner similar to CZA. Alternatively, management of CYA may include multiplexing one or more OCT imaging modules for increasing the size of the OCT imaging module's focal plane for irregular geometric features on the object such as a side mirror on a vehicle. Further, curvature about the x-axis (CXA) may be managed in a manner similar to that of CZA or CYA.

In an embodiment, the motion control system computes a motion control operation using the geometric model and/or position tracking information in combination with control logic that can sequence a compensation for one or more of CZA, CYA, and CXA to facilitate scanning of the object by the OCT imaging module with reduced multiplexing requirements.

In a particular case, the motion control system operates similar to a data set operator (DSO) that converts object geometry surface profile into one or more motion control sequences. In some cases, this may operate in a manner similar to a genetic evolution algorithm that maps OCT imaging module target locations on the surface of the object to an overall coverage score. A high performance computer (HPC) may then be used to increase the coverage performance. Another DSO may take a motion control sequence that an individual OCT imaging module is to follow and render it to OpenGL. A computing module can play the motion control sequence to be followed by an individual OCT imaging module in a manner similar to a MIDI sequencer.

In implementing a system comprising an OCT imaging module and motion control as described herein, the following steps may occur at an individual OCT module. A 3D geometry strip can be obtained from a 3D model of the object. The 3D model may be provided to and/or generated by the system, such as as described herein (e.g. CAD model; 3D model generated via laser scanning device). The back of the focal plane can be plane fit such that lower altitudes in the surface of the object are covered. Geometry that peaks above the front of the focal plane can be highlighted. For an area that either sticks above the focal plane or requires compensation for curvature around the x-, y-, or z-axis, a compensating positioning command can be fit that reduces or minimizes the loss of coverage from the areas in question, and the other areas.

In an embodiment, a plurality of A scans representing individual depth scans of a particular point on the surface of the object can be aggregated by the computing module, in order to generate a B-scan. In some cases, B-scans may have a width in the millimeter range. A plurality of B scans can be stacked, and the computing module can perform an averaging operation along an axis (e.g. z axis). This can be done by taking an average of a series of points, each point having the same location/position in a B-scan, to generate a compressed (averaged) B-scan from a massive volume of B-scans. To achieve compression of the volume of B-scans, a transform is applied to the volume/plurality of B-scans. By compressing the B-scans, the imaging data can be more easily sent over a network (i.e.reduced computational requirements), which may simplify training of a computational module such as a neural network (e.g. by reducing the number of training samples) or may simplify the application of other machine learning techniques simpler. In other words, a three dimensional array of B-scans is generated and transformed into a two dimensional array having the same dimensions as a B-scan. Once transformed, standard image processing techniques (e.g. edge detection; normalization of data) can be applied to the transformed B-scan and feature detection carried out, for example by using Gabor wavelets.

In an embodiment, the detection of surface defects and other processing of imaging data for evaluation purposes can be based on computational modules. Computational modules can be implemented using any computational paradigm capable of performing data analysis based on various methods such as regression, classification and others. In some variations, the computational modules can be learning based. One learning based computational paradigm capable of performing such methods may be a neural network. Neural networks may include Restricted Boltzmann Machines, Deep Belief Networks, and Deep Boltzmann Machines. Accordingly, a neural network can be used to detect the presence or absence of a surface defect or irregularity in a target object by the OCT imaging module. Thus, imaging data representing individual depth scans (e.g. A-scans) or aggregated depth scans (two dimensional B-scans; three dimensional C-scans) completed by the OCT imaging module, as well as relevant data from databases and other services, can be provided to a neural network, which can perform detection based on classification/regression or similar methods.

Particularly, variations of the present disclosure may include signal processing of OCT or hyperspectral imaging data by machine learning techniques (e.g. neural networks) according to binary classification or defect classification modalities. In a binary classification modality, a computational module detects only the presence or absence of a defect in the surface being inspected, represented in the imaging data. A computational module employing a binary detection modality may utilize machine learning techniques such as feature engineering (e.g. Gabor filters, image processing algorithms, Gaussian wavelet) or supervised learning (e.g. LSTM), or other appropriate techniques. Alternatively, a defect classification modality may be used, wherein the computational module identifies a particular defect type based on the imaging data collected from the surface under inspection. For example, in a defect classification modality employed in an automotive manufacturing paint environment, the computational module can distinguish between and identify different kinds of known defect types (e.g. seed, crater, fiber) from the imaging data.

In some variations, the neural network can operate in at least two modes. In a first mode, a training mode, the neural network can be trained (i.e. learn) based on known surfaces containing the known presence or absence of a defect. The training typically involves modifications to the weights and biases of the neural network, based on training algorithms (backpropagation) that improve its detection capabilities. In a second mode, a normal mode, the neural network can be used to detect a defect in the surface of a target object under inspection. In variations, some neural networks can operate in training and normal modes simultaneously, thereby both detecting the presence or absence of a defect in the surface of a given target object, and training the network based on the detection effort performed at the same time to improve its detection capabilities. In variations, training data and other data used for performing detection services may be obtained from other services such as databases or other storage services. Some computational paradigms used, such as neural networks, involve massively parallel computations. In some implementations, the efficiency of the computational modules implementing such paradigms can be significantly increased by implementing them on computing hardware involving a large number of processors, such as graphical processing units.

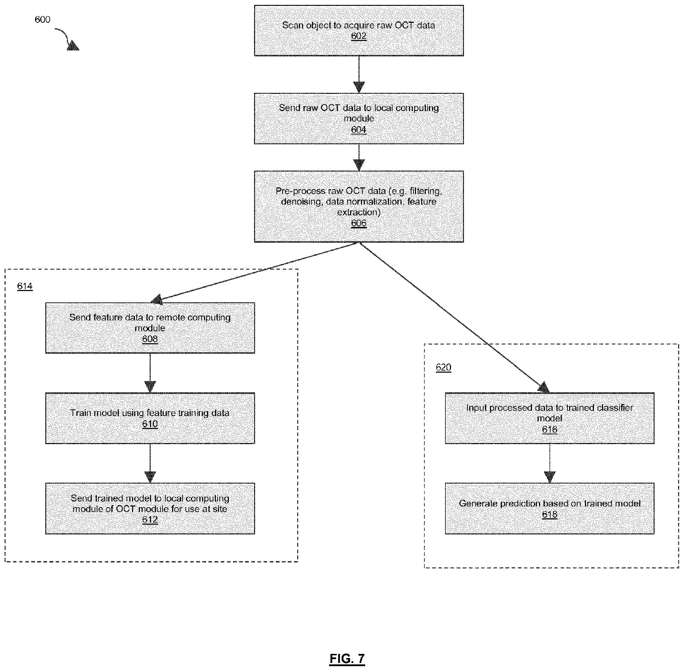

Referring now to FIG. 7, in accordance with an embodiment, shown therein is a method 600 for inspecting a surface for defects using a neural network, for use at a local OCT imaging module of a distributed surface inspection system. The method 600 shows both a training mode 614 and a normal mode 620 which, in some embodiments, may operate simultaneously at the local OCT imaging module. At 602, the OCT imaging module scans the object, acquiring raw OCT data. At 604, the raw data is sent from the OCT module to the local computing module. In some cases, the local computing module may be embedded in the OCT imaging module. At 606, the raw OCT data is pre-processed, which may include the application of filtering, denoising, data normalization, and feature extraction techniques, and the like. By applying feature extraction techniques to the raw data, feature data is generated. Features calculated at the local computing module may use classification and analysis services of the remote computing module. At 608, the feature data can be sent to a remote computing module, that may be accessible via a private or external network and may reside in the cloud. Optionally, the raw OCT data may be sent to the remote computing module for pre-processing and computing of feature vectors. Features or raw data may be anonymized, encrypted, compressed, logged for auditing, and associated with a jurisdictional identifier prior to transfer to and from the remote computing module. The remote computing module includes a computational module, such as a neural network, which may, at 610, be trained using the training data. In some cases, training data may be collected from cloud storage, in addition to or instead of training data collected from the inspection site. Training data may be labelled and used as reference data to train the computational module, such as a classification model, in a supervised learning method. In alternate embodiments, unsupervised or semi-supervised training methods may be used to generate a trained computational module. Once a model is trained, the model may be encrypted, compressed, logged for auditing, anonymized and/or associated with a jurisdictional identifier before transfer to or from the cloud. Once models trained at the remote computing module are ready, they can be deployed by pushing to the inspection site remotely, or pulling from the remote computing module from the site. At 612, the trained model of the computational module is sent to the local computing module to be used by the OCT system at the inspection site (i.e. in normal mode 620). In some cases, the trained model comprises a classification model for determining the presence of defects in the surface of an object. Once deployed, remote computing module-trained (e.g. cloud-trained) models may be pushed back to the remote computing module for reconfiguration, further training or analysis.

Operating in normal mode 620, raw OCT data is acquired at block 602. At 604, raw OCT data is sent to the local computing module. At 606, the raw data is preprocessed, which may include feature extraction. At 616, the processed OCT data is used as input for the trained model. At 618, a prediction is generated by the trained model, which may be output to a user via an output interface of the local computing module.

In some cases, models may be locally trained (i.e. on local computing module) and may be employed on the machines they are trained on, or deployed to other local machines. Locally trained models may also be pushed to the cloud for recongifuration, further training, or analysis.

In some cases, pre-processing can take place on an OCT module that has been enhanced with compute resources e.g. system-on-a-chip ("SoC"), or connected to a field programmable gate array (FPGA) fabric, application specific integrated circuit (ASIC), local servers at the inspection site or cloud servers.

In an embodiment, a learning-based computational module is capable of performing/performs training and/or classification on interferometric data. Interferometric data may, for example, be represented by a voltage value at a given time, wherein the voltage output by the detector corresponds with the measured light intensity striking the detector at a particular time. A series of voltage values may be obtained and plotted over time to obtain an interferogram. In many OCT applications, including embodiments described in the present disclosure, the interferogram is transformed into a plot of amplitude over frequency, which may be done by mathematical computation known in the art such as Fast Fourier Transform (FFT), and can be further processed for imaging purposes. The transformation process of the interferometric data (interferogram) can be expensive and require significant computational resources. Removal of the transformation step is thus desirable for lowering computational requirements. Accordingly, a computational module (e.g. neural network) can be used along with interferometric and other data in training a model, such as a classification model, that can be used to identify surface defects or other conditions of interest in a target surface on the basis of the interferometric data. The trained model capable of performing classification on interferometric data may be trained and distributed in a manner similar to that previously described in reference to FIG. 7. For example, this may include distribution of the trained model to the local computing module of a local OCT imaging module for classification of defects at the individual sensor unit. Other variations may have training completed at the remote computing module and interferometric data sent from an individual OCT imaging module to the remote computing module for classification by the trained model.

Classification should be understood in a larger context than simply to denote supervised learning. By classification process we convey: supervised learning, unsupervised learning, semi-supervised learning, active/groundtruther learning, reinforcement learning and anomaly detection. Classification may be multi-valued and probabilistic in that several class labels may be identified as a decision result; each of these responses may be associated with an accuracy confidence level. Such multi-valued outputs may result from the use of ensembles of same or different types of machine learning algorithms trained on different subsets of training data samples. There are various ways to aggregate the class label outputs from an ensemble of classifiers; majority voting is one method.

Embodiments of the systems and methods of the present disclosure may implement groundtruthing to ensure classification result accuracy according to an active learning technique. Specifically, results from classification models may be rated with a confidence score, and high uncertainty classification results can be pushed to a groundtruther to verify classification accuracy. Optionally, classification outputs can periodically be provided to groundtruthers to ensure accuracy. In some implementations, a determination by the system indicative of the presence of a defect may result in generating a request for human groundtruthing of the detection signal or the target surface from which the detection signal was generated.

In variations, surface defect detection using a neural network or clustering mechanism can be an ongoing process. For example, in some implementations, the computing module can be a local computing module and provide results to a remote computing module. The remote computing module can include appropriate learning mechanisms to update a training model based on the newly received signals. For example, the remote computing module can be a neural network based system implemented using various application programming interfaces APIs and can be a distributed system. The APIs included can be workflow APIs, match engine APIs, and signal parser APIs, allowing the remote computing module to both update the network and determine whether a defect is present or absent in the target surface based on the received detection signal.

Further embodiments will now be described relating to variations of the above systems and methods implementing machine-learning processing techniques. Machine learning-implemented processing techniques, particularly making use of neural networks, may facilitate: analysis of imaging data (e.g. OCT and hyperspectral imaging data), which may include generating a multi-dimensional image of the target surface; and denoising and calibrating imaging data. These techniques may be carried out by a computing module and/or by a remote computing module.

Analysis of imaging data may be implemented by providing input data to a neural network, such as a feed-forward neural network, for generating at least one output. The neural networks described below may have a plurality of processing nodes, including a multi-variable input layer having a plurality of input nodes, at least one hidden layer of nodes, and an output layer having at least one output node. During operation of a neural network, each of the nodes in the hidden layer applies a function and a weight to any input arriving at that node (from the input layer of from another layer of the hidden layer), and the node may provide an output to other nodes (of the hidden layer or to the output layer). The neural network may be configured to perform a regression analysis providing a continuous output, or a classification analysis to classify data. The neural networks may be trained using supervised or unsupervised (or semi-supervised) learning techniques, as described above. According to a supervised learning technique, a training dataset is provided at the input layer in conjunction with a set of known output values at the output layer. During a training stage, the neural network may process the training dataset. It is intended that the neural network learn how to provide an output for new input data by generalizing the information it learns in the training stage from the training data. Training may be effected by backpropagating error to determine weights of the nodes of the hidden layers to minimize the error. The training dataset, and the other data described herein, can be stored in a database connected to the computing module, or otherwise accessible to remote computing module. Once trained, or optionally during training, test data can be provided to the neural network to provide an output. A neural network may thus cross-correlate inputs provided to the input layer in order to provide at least one output at the output layer. Preferably, the output provided by a neural network in each embodiment will be close to a desired output for a given input, such that the neural network satisfactorily processes the input data.

According to a further embodiment, machine learning techniques may be applied in order to improve denoising of imaging data. Particularly, a neural network may be trained to denoise imaging data for a given pattern of noise, saturation, such as vibration, acceleration, direction etc. Particularly, a motion vector and imaging data may be provided to a neural network at its input layer, with a desired output compensating for defects in the imaging data that may be caused by the motion of the target object (and surface) for the motion vector. The neural network may be trained such that the output layer provides clean imaging data compensating for motion and saturation defects. The neural network may be trained with a training dataset comprising, at the input layer, imaging data comprising motion and saturation defects and associated motion vectors, and with associated clean imaging data at the output layer, free of motion and saturation defects. Accordingly, such a trained neural network learns a pattern of defects exhibited in the presence of a given motion vector, in order to generate clean imaging data as the output, free of motion and saturation defects.

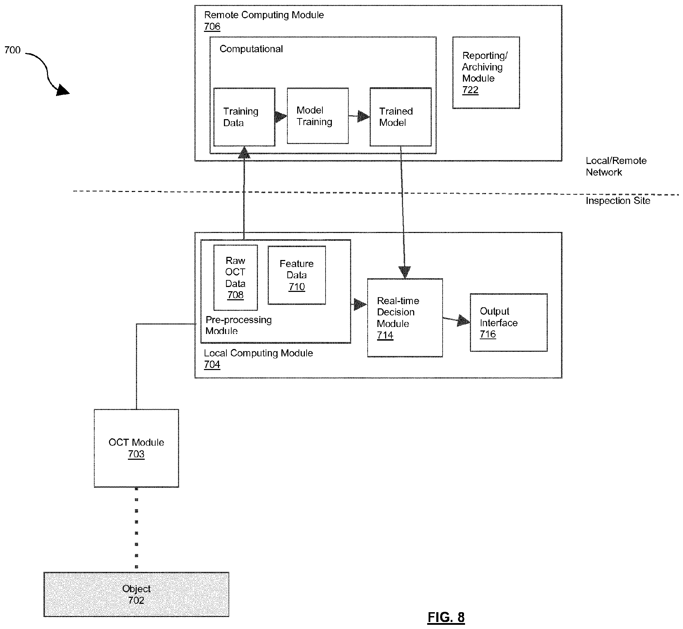

Referring now to FIG. 8, shown therein is a surface inspection system 700 using an OCT imaging modality, operating in training and normal modes simultaneously, in accordance with an embodiment. The system 700 comprises a distributed system including an OCT imaging module 703 for scanning an object 702 and acquiring imaging data therefrom and a local computing module 704, each located at an inspection site, and a remote computing module 706 communicatively linked to the system 700 via a network. In some cases, remote computing module 706 resides in the cloud. The object 702 may comprise an object, material, sample, etc. in which it is desired to detect the presence or absence of a surface defect. The OCT imaging module 703 interrogates the object 702 with a light beam emitted by an optical source and collects a signal corresponding to the interaction of the light beam with the object 702. The signal generated comprises raw OCT data that can be sent from the OCT module 703 to the local computing module 704. Once received by the local computing module 704, the raw data is processed, which may include feature extraction. Though shown as occurring at local computing module 704, processing of raw data may occur at the local computing module 704, the remote computing module 706, or both. Raw data 708 or processed feature data 710 can be sent from local computing module 704 to remote computing module 706, where it can be used as training data in training a computational module 712 (e.g. neural network). Training via the computational module 712 can produce a trained model, which can then be sent to a real-time decision module 714 of the local computing module 704 for use at the inspection site in a surface inspection operation. The real-time decision module may be configured to generate a determination as to the presence of defects in the object surface based on the imaging data. In a further aspect of the system 700, the pre-processed data can be sent to the real-time decision module 714 for classification by the trained classification model. The output of the real-time decision module 714 can be provided to a user via an output interface 716. After the processed data has been applied to the trained model at the real-time decision module 714, the determination can also be locally stored on local computing module 704. Locally stored data may be sent from the local computing module 704 to the remote computing module 706 for reporting/archiving 722.

The present disclosure teaches a system and method for surface inspection using an OCT imaging modality. Defects in a surface are detected through using an OCT imaging module to generate imaging data and applying signal processing (e.g. machine learning) techniques to the imaging data. The imaging data may include hyperspectral imaging data in addition to OCT imaging data, with hyperspectral and OCT imaging data generated via a common optical pathway in the OCT imaging module.. By applying machine learning techniques to imaging data generated by the OCT imaging module, surface inspection processes can be increasingly automated, thereby reducing the requirement for human intervention in various industrial processes such as manufacturing and construction, and ultimately improving efficiency and accuracy.

The above described embodiments of the invention are intended to be examples of the present disclosure and alterations and modifications may be effected thereto, by those of skill in the art, without departing from the scope of the present disclosure, which is defined solely by the claims appended hereto. For example, systems, methods, and embodiments discussed can be varied and combined, in full or in part.

Thus, specific surface inspection systems and methods using an OCT imaging modality have been disclosed. It should be apparent, however, to those skilled in the art that many more modifications besides those already described are possible without departing from the inventive concepts herein. The subject matter of the present disclosure, therefore, is not to be restricted except in the spirit of the disclosure. Moreover, in interpreting the present disclosure, all terms should be interpreted in the broadest possible manner consistent with the context. In particular, the terms "comprises" and "comprising" should be interpreted as referring to elements, components, or steps in a non-exclusive manner, indicating that the referenced elements, components, or steps may be present, or utilized, or combined with other elements, components, or steps that are not expressly referenced.

Systems and methods for surface inspection for imaging an object via an optical coherence tomography (OCT) imaging modality are provided. The system includes an OCT imaging module for generating imaging data from a surface under inspection, including: an electromagnetic radiation source for interrogating the object with light; an optical system having an interferometer for generating an interference pattern corresponding to the light backscattered from the object; and a detector for detecting the interference pattern and generating imaging data therefrom; a motion controller device for moving at least one component of the OCT imaging module relative to the object, the motion controller device moving the OCT imaging module such that a surface of the object is within a depth of field of the OCT imaging module; and a computational module for: aggregating the imaging data; and determining the presence or absence of surface defects in the imaging data.

## Claims

1. A surface inspection system for imaging an object via an optical coherence tomography (OCT) imaging modality, the system comprising:
an OCT imaging module for generating imaging data from a surface of the object, comprising:
an electromagnetic radiation source for interrogating the object with light; an optical system having an interferometer for generating an interference pattern corresponding to the light backscattered from the object; and
a detector for detecting the interference pattern and generating imaging data therefrom;
a motion controller device for moving at least one component of the OCT imaging module relative to the object, the motion controller device moving the at least one component of the OCT imaging module such that the surface of the object is within a depth of field of the OCT imaging module; and
a computational module for:
aggregating the imaging data; and
determining the presence or absence of surface defects in the imaging data.

2. The system of claim 1, wherein moving the at least one component of the OCT imaging module comprises translating or rotating of the at least one component of the OCT imaging module relative to the object.

3. The system of claim 2, wherein moving the at least one component of the OCT imaging module comprises radial actuation of the at least one component of the OCT imaging module to maintain a predetermined angle of incidence between the OCT imaging module and the surface of the object.

4. The system of claim 2, wherein moving the at least one component of the OCT imaging module comprises linear actuation of the at least one component of the OCT imaging module to maintain a predetermined distance between the OCT imaging module and object, the predetermined distance enabling the surface of the object to be in focus of the OCT imaging module.

5. The system of claim 1, wherein the motion controller device moves the at least one component of the OCT imaging module based on a motion control model, the motion control model using geometries of the surface of the object such that the surface of the object is within a depth of field of the OCT imaging module.

6. The system of claim 5, wherein the geometries of the surface of the object are pre-existing geometries received by the motion controller device.

7. The system of claim 5, wherein the geometries of the surface of the object are measured using a positional sensor directed at the object.

8. The system of claim 1, wherein the computational module comprises a neural network for receiving the imaging data at an input layer and generating the determination at an output layer based on a trained classification model.

9. The system of claim 8, wherein the imaging data comprises interferometric data generated by the optical system of the OCT imaging module.

10. The system of claim 8, wherein the classification model can be based on supervised learning, unsupervised learning, semi-supervised learning, groundtruther learning, or reinforcement learning.

11. A method for surface inspection for imaging an object via an optical coherence tomography (OCT) imaging modality using an OCT imaging module, the method comprising:
moving at least one component of the OCT imaging module relative to the object such that a surface of the object is within a depth of field of the OCT imaging module;
performing, with the OCT imaging module:
interrogating the object with light from a light source;
detecting light backscattered from the object to detect an interference pattern; and
generating imaging data from the interference pattern;
aggregating the imaging data; and
determining the presence or absence of surface defects in the imaging data.

12. The method of claim 11, wherein moving the at least one component of the OCT imaging module comprises translating or rotating of the at least one component of the OCT imaging module relative to the object.

13. The method of claim 12, wherein moving the OCT imaging module comprises radial actuation to maintain a predetermined angle of incidence between the OCT imaging module and the surface of the object.

14. The method of claim 12, wherein moving the at least one component of the OCT imaging module comprises linear actuation of the at least one component of the OCT imaging module to maintain a predetermined distance between the OCT imaging module and object, the predetermined distance enabling the surface of the object to be in focus of the OCT imaging module.

15. The method of claim 11, wherein the at least one component of the OCT imaging module is moved based on a motion control model, the motion control model using geometries of the surface of the object such that the surface of the object is within a depth of field of the OCT imaging module.

16. The method of claim 15, wherein the geometries of the surface of the object are pre-existing geometries.

17. The method of claim 15, wherein the geometries of the surface of the object are measured using a positional sensor directed at the object.

18. The method of claim 11, wherein determining the presence or absence of surface defects comprises using a neural network for receiving the imaging data at an input layer and generating the determination at an output layer based on a trained classification model.

19. The method of claim 18, wherein the imaging data comprises interferometric data generated by the OCT imaging module.

20. The method of claim 11, further comprising denoising the imaging data using a neural network.
